(19) Europäisches Patentamt
European Patent Office
Office européen des brevets

(11) **EP 4 650 497 A1**

(12) **EUROPEAN PATENT APPLICATION**
published in accordance with Art. 153(4) EPC

(43) Date of publication:
**19.11.2025 Bulletin 2025/47**

(21) Application number: **23916238.1**

(22) Date of filing: **20.12.2023**

(51) International Patent Classification (IPC):
**C30B 29/04** (2006.01)   **C01B 32/25** (2017.01)

(52) Cooperative Patent Classification (CPC):
**C01B 32/25; C30B 29/04**

(86) International application number:
**PCT/JP2023/045616**

(87) International publication number:
**WO 2024/150624 (18.07.2024 Gazette 2024/29)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.01.2023 JP 2023002185**

(71) Applicant: **SUMITOMO ELECTRIC INDUSTRIES,
LTD.
Osaka-shi, Osaka 541-0041 (JP)**

(72) Inventors:
• **SUMIYA, Hitoshi**
  **Osaka-shi, Osaka 541-0041 (JP)**
• **MUTO, Haruka**
  **Osaka-shi, Osaka 541-0041 (JP)**
• **NISHIYAMA, Norimasa**
  **Osaka-shi, Osaka 541-0041 (JP)**

(74) Representative: **Boult Wade Tennant LLP
Salisbury Square House
8 Salisbury Square
London EC4Y 8AP (GB)**

(54) **SYNTHETIC MONOCRYSTALLINE DIAMOND**

(57)    This synthetic monocrystalline diamond contains nitrogen atoms at a concentration of 200-1500 ppm based on numbers of atoms. The following satisfy formula A: A Raman shift $\lambda 1$ cm$^{-1}$ of a peak in a primary Raman scattering spectrum of the synthetic monocrystalline diamond; and a Raman shift $\lambda 2$ cm$^{-1}$ of a peak in a primary Raman scattering spectrum of a synthetic type IIa monocrystalline diamond in which the concentration of nitrogen atoms is 1 ppm or less based on numbers of atoms. Formula A:

$$-0.85 < \lambda 1 - \lambda 2 \leq -0.15.$$

FIG.1

EP 4 650 497 A1

**Description**

TECHNICAL FIELD

The present disclosure relates to a synthetic single crystal diamond. The present application claims a priority based on Japanese Patent Application No. 2023-002185 filed on January 11, 2023. The entire content described in the Japanese Patent Application is entirely incorporated by reference herein.

BACKGROUND ART

Since single crystal diamonds have high hardness, they are widely used for tools such as a cutting tool, a grinding tool, and a wear-resistant tools. The single crystal diamonds used for the tools include natural diamond and synthetic diamond.

Most of the natural diamonds contain an aggregation-type nitrogen atom as an impurity (Ia type). The aggregation-type nitrogen atom in the diamond crystal can suppress development of plastic deformation and cracking that occur when diamond is used for a tool. Thus, the natural diamond has high mechanical strength. However, the natural diamond has a large variation of quality and is not supplied in a stable amount, and thus, there is a limitation in the use of the natural diamond for industrial applications.

On the other hand, the synthetic diamond is widely used in industrial fields because it has constant quality and can be stably supplied.

A typical synthetic diamond contains an isolated substitutional nitrogen atom as an impurity (Ib type). The mechanical properties of diamond tend to deteriorate as the concentration of the isolated substitutional nitrogen atoms in the diamond crystal increases. Thus, when the Ib type synthetic diamond is used for a tool, wear or breakage of the cutting edge tends to occur.

Furthermore, there is a synthetic diamond (IIa type) which contains almost no nitrogen impurities. Since the IIa type synthetic diamond does not contain impurities or crystal defects which inhibit development of cracking, when used for a tool, breakage of the cutting edge tends to occur.

Therefore, techniques for improving wear resistance and breakage resistance of the synthetic diamond have been studied.

For example, Patent Literature 1 (WO 2019/077888) discloses a synthetic single crystal diamond having high hardness and excellent breakage resistance.

CITATION LIST

PATENT LITERATURE

PTL 1: WO 2019/077888

SUMMARY OF INVENTION

A synthetic single crystal diamond of the present disclosure is a synthetic single crystal diamond including nitrogen atoms at a concentration of 200 ppm to 1500 ppm in terms of number of atoms. A Raman shift $\lambda1$ cm$^{-1}$ of a peak in a first-order Raman scattering spectrum of the synthetic single crystal diamond and a Raman shift $\lambda2$ cm$^{-1}$ of a peak in a first-order Raman scattering spectrum of a synthetic IIa-type single crystal diamond that has a concentration of nitrogen atoms of 1 ppm or less in terms of number of atoms exhibit a relationship of the following Formula A,

$$-0.85 < \lambda1 - \lambda2 \leq -0.15 \qquad \text{Formula A.}$$

BRIEF DESCRIPTION OF DRAWINGS

[FIG. 1] FIG. 1 is a schematic cross-sectional view showing an example of a sample chamber configuration used for manufacturing a synthetic single crystal diamond according to an embodiment of the present disclosure.
[FIG. 2] FIG. 2 is a schematic view of a sliding test apparatus.

DETAILED DESCRIPTION

[Problems to be Solved by the Present Disclosure]

In conventional wire drawing dies, scribing tools, wire guides, burnishing tools and the like using synthetic diamond, when a workpiece is slid under a low load, and at a high speed or for a long time, wear tends to progress relatively quickly.

Accordingly, an object of the present disclosure is to provide a synthetic single crystal diamond having excellent wear resistance, particularly even in sliding processing under a low load for a long time.

[Advantageous Effect of Present Disclosure]

According to the present disclosure, it is possible to provide a synthetic single crystal diamond having excellent wear resistance, particularly even in processing under a low load for a long time.

[Description of Embodiments]

First, embodiments of the present disclosure will be listed and described.

(1) A synthetic single crystal diamond of the present disclosure is a synthetic single crystal diamond including nitrogen atoms at a concentration of 200 ppm to 1500 ppm in terms of number of atoms. A Raman shift $\lambda 1$ cm$^{-1}$ of a peak in a first-order Raman scattering spectrum of the synthetic single crystal diamond and a Raman shift $\lambda 2$ cm$^{-1}$ of a peak in a first-order Raman scattering spectrum of a synthetic IIa-type single crystal diamond that has a concentration of nitrogen atoms of 1 ppm or less in terms of number of atoms exhibit a relationship of the following Formula A,

$$-0.85 < \lambda 1 - \lambda 2 \leq -0.15 \qquad \text{Formula A.}$$

According to the present disclosure, it is possible to provide a synthetic single crystal diamond having excellent wear resistance, particularly even in processing under a low load for a long time.
(2) In the above (1), a half width W of the peak in the first-order Raman scattering spectrum of the synthetic single crystal diamond may be 2.7 cm$^{-1}$ to 4.5 cm$^{-1}$. According to this, when the synthetic single crystal diamond is used as a material for a wear-resistant tool such as a die, the tool can have excellent wear resistance for a long time.
(3) In the above (1) or (2), in an infrared absorption spectrum of the synthetic single crystal diamond measured by Fourier-transform infrared spectrometry, an absorption peak may be present within a wavenumber range of 2680 cm$^{-1}$ to 2695 cm$^{-1}$. The synthetic single crystal diamond having the absorption peak has further improved sliding property.
(4) In any one of (1) to (3), in an infrared absorption spectrum of the synthetic single crystal diamond measured by Fourier-transform infrared spectrometry, a maximum absorption intensity IA of an absorption peak within a wavenumber range of a 2680 cm$^{-1}$ to 2695 cm$^{-1}$ may be 1.0% or more of an absorption intensity IB at a wavenumber of 2160 cm$^{-1}$. According to this, the synthetic single crystal diamond has further improved sliding property.
(5) In any one of (1) to (4), a Knoop hardness in a <100> direction on a {001} plane of the synthetic single crystal diamond may be 65 GPa to 90 GPa. Here, the Knoop hardness is measured in accordance with JIS Z 2251:2009 under conditions of a temperature of 23°C±5°C and a test load of 4.9 N. When the {001} <100> Knoop hardness of the synthetic single crystal diamond is 65 GPa or more, the synthetic single crystal diamond is much harder than metallic materials, and thus can be suitably used for processing metallic materials such as SUS, Ni alloys, and Ti alloys.
(6) In any one of (1) to (5), an absorption peak derived from an aggregate of nitrogen atoms may be absent in an infrared absorption spectrum of the synthetic single crystal diamond measured by Fourier-transform infrared spectrometry. According to this, since most of the nitrogen atoms in the synthetic single crystal diamond are present as isolated substitutional nitrogen atoms, tensile stress is likely to increase, and an effect of suppressing abrasion and wear is improved.

[Detailed Description of Embodiments]

< Existence Form of Nitrogen Atoms in Diamond Crystal>

To deepen understanding of the synthetic single crystal diamond of the present disclosure, existence form of nitrogen atoms that are present as an impurity in the crystal, which are one of the major factors to determine characteristics of diamond, will be firstly described.

Nitrogen atoms in the diamond crystal can be classified into an isolated substitutional nitrogen atom, an aggregation-type nitrogen atom, and the like according to their existence form.

The isolated substitutional nitrogen atom (C center) is a nitrogen atom present at a position of a carbon atom in the diamond crystal by substitution in one atomic unit.

A synthetic single crystal diamond that contains the isolated substitutional nitrogen atom exhibits an absorption peak near a wavenumber of 1130 cm$^{-1}$ (that is, wavenumber of 1130$\pm$2 cm$^{-1}$) in an infrared absorption spectrum measured by Fourier-transform infrared spectrometry.

In the synthetic single crystal diamond that contains the isolated substitutional nitrogen atoms, an unpaired electron derived from the nitrogen atom is present, and a concentration of the isolated substitutional nitrogen atoms can be measured by electron spin resonance (ESR) analysis. The ESR also detects a signal of not only the isolated substitutional nitrogen atoms but also crystal defects that have an unpaired electron, and the like. In this case, the isolated substitutional nitrogen atoms can be separately detected with g-value or a relaxation time of the signal.

The aggregation-type nitrogen atoms are two or more nitrogen atoms present with aggregation in the diamond crystal.

The aggregation-type nitrogen atoms are present in an A center (nitrogen atom pair), a B center (condensation of four nitrogen atoms), a B' center (platelet), an H3 center (aggregation of two nitrogen atoms), an N3 center (aggregation of three nitrogen atoms), and the like.

The A center (nitrogen atom pair) is an aggregate composed of two nitrogen atoms, and the two nitrogen atoms are covalently bonded, and carbon atoms that constitute the diamond crystal are substituted with the respective nitrogen atoms. A diamond that contains the A center (nitrogen atom pair) is called IaA type. A synthetic single crystal diamond that contains the A center (nitrogen atom pair) exhibits an absorption peak near a wavenumber of 1282 cm$^{-1}$ (for example, a wavenumber of 1282$\pm$2 cm$^{-1}$) in an infrared absorption spectrum measured by Fourier-transform infrared spectrometry.

The B center (aggregation of four nitrogen atoms) is an aggregate composed of one vacancy and four nitrogen atoms present adjacent to the vacancy, and carbon atoms that constitute the diamond crystal are substituted with the respective nitrogen atoms.

A diamond that contains an aggregation of four nitrogen atoms is called IaB type. The synthetic single crystal diamond that contains the aggregation of four nitrogen atoms exhibits an absorption peak of a wavenumber of near 1175 cm$^{-1}$ (for example, a wavenumber of 1175$\pm$2 cm$^{-1}$) in an infrared absorption spectrum measured by Fourier-transform infrared spectrometry.

The B' center (also called platelet) is a plate-shaped aggregate composed of five or more nitrogen atoms and an interlattice carbon, and incorporated as an inclusion in the crystal.

A diamond that contains the B' center (platelet) is called IaB' type. The synthetic single crystal diamond that contains the B' center (platelet) exhibits an absorption peak at a wavenumber of 1358 cm$^{-1}$ to 1385 cm$^{-1}$ in the infrared absorption spectrum measured by Fourier-transform infrared spectrometry.

The H3 center (aggregation of two nitrogen atoms) is an aggregate composed of one vacancy and two nitrogen atoms present adjacent to the vacancy, and carbon atoms that constitute the diamond crystal are substituted with the respective nitrogen atoms. Herein, "nitrogen atom present adjacent to a vacancy" means a nitrogen atom positioned in the shortest interatomic distance with a carbon atom hypothetically present in a position of the vacancy (that is, "nearest neighbor"). The same applies to the N3 center and the B center, described later.

A synthetic single crystal diamond that contains the H3 center (aggregation of two nitrogen atoms) exhibits an emission peak near a fluorescent wavelength of 503 nm (e.g., fluorescent wavelength of 503$\pm$2 nm) in a fluorescence spectrum obtained by irradiating the synthetic single crystal diamond with excitation light at a wavelength of shorter than approximately 500 nm, for example a wavelength of 325 nm.

The N3 center (aggregation of three nitrogen atoms) is an aggregate composed of one vacancy and three nitrogen atoms present adjacent to the vacancy, and carbon atoms that constitute the diamond crystal are substituted with the respective nitrogen atoms.

A synthetic single crystal diamond that contains the N3 center (aggregation of three nitrogen atoms) exhibits an emission peak within one or both of a fluorescent wavelength range of near 415 nm (for example, a fluorescent wavelength of 415$\pm$2 nm) and a fluorescent wavelength range of 420 nm to 470 nm in a fluorescence spectrum obtained by irradiating the synthetic single crystal diamond with excitation light at a wavelength of shorter than approximately 410 nm, for example a wavelength of 325 nm.

First, the present inventors have studied a form of wear when a conventional synthetic single crystal diamond is used for sliding processing under a low load for a long time. As a result, it has been presumed that the wear that occurs when the synthetic single crystal diamond is used for the sliding processing under a low load for a long time is not wear caused by mechanical fracture (accumulation of micro cleavage), but abrasion and wear caused by detachment of atoms due to accumulation of fatigue caused by sliding under a low load for a long time.

As a result of intensive studies, the present inventors have newly found that when a synthetic single crystal diamond contains a large amount of nitrogen (200 to 1500 ppm) as isolated substitutional nitrogen atoms in the crystal, the occurrence of abrasion and wear is suppressed, and have completed the present disclosure.

Specific examples of the synthetic single crystal diamond of the present disclosure are described below. In the drawings of the present disclosure, a same reference sign represents same parts or corresponding parts. A size relationship of length, width, thickness, depth, and the like are appropriately modified for clarify and simplify the drawings, and not necessarily illustrates an actual size relationship.

The description form "A to B" herein means "A or more and B or less". When there is not description on a unit of A and only a unit of B is described, the unit of A and the unit of B are same.

When one or more values are each described in the present disclosure as lower limits and upper limits of numerical ranges, combinations of any one value described as a lower limit and any one value described as an upper limit are also described.

[Embodiment 1: Synthetic Single Crystal Diamond]

A synthetic single crystal diamond according to an embodiment of the present disclosure (hereinafter, also referred to as "the present embodiment") is a synthetic single crystal diamond including nitrogen atoms at a concentration of 200 ppm to 1500 ppm in terms of number of atoms. A Raman shift $\lambda 1$ cm$^{-1}$ of a peak in a first-order Raman scattering spectrum of the synthetic single crystal diamond and a Raman shift $\lambda 2$ cm$^{-1}$ of a peak in a first-order Raman scattering spectrum of a synthetic IIa-type single crystal diamond that has a concentration of nitrogen atoms of 1 ppm or less in terms of number of atoms exhibit a relationship of the following Formula A,

$$-0.85 < \lambda 1 - \lambda 2 \leq -0.15 \quad \text{Formula A.}$$

The synthetic single crystal diamond of the present embodiment can have excellent wear resistance, particularly even in processing under a low load for a long time. The reason for this is not clear, but presumed as the following (i) and (ii).

(i) The synthetic single crystal diamond of the present embodiment contains nitrogen atoms at a concentration of 200 ppm to 1500 ppm in terms of number of atoms. Furthermore, the Raman shift $\lambda 1$ cm$^{-1}$ of the peak in the first-order Raman scattering spectrum of the synthetic single crystal diamond of the present embodiment and the Raman shift $\lambda 2$ cm$^{-1}$ of the peak in the first-order Raman scattering spectrum of the synthetic IIa-type single crystal diamond that has a concentration of nitrogen atoms of 1 ppm or less in terms of number of atoms exhibit the relationship of the following Formula A.

$$-0.85 < \lambda 1 - \lambda 2 \leq -0.15 \quad \text{Formula A}$$

In the synthetic single crystal diamond of the present embodiment, a large number of nitrogen atoms exist as isolated substitutional nitrogen atoms. According to this, strong tensile stress is generated in the crystal lattice of the synthetic single crystal diamond. It is presumed that the tensile stress suppresses abrasion and wear caused by the detachment of atoms due to accumulation of fatigue. The relationship between the above formula A and each of the existence form of nitrogen atoms in the synthetic single crystal diamond and the internal stress of the synthetic single crystal diamond will be described in detail later.

(ii) It is presumed that, by the synthetic single crystal diamond of the present embodiment containing a large amount of nitrogen, a state of electron at the surface of the synthetic single crystal diamond is changed, and thus, the sliding property is improved, and the friction coefficient is reduced.

When the isolated substitutional nitrogen atom is contained in a single crystal diamond, local tensile stress is generated in the crystal lattice around the isolated substitutional nitrogen atom. Thus, the isolated substitutional nitrogen atom becomes a starting point for plastic deformation or fracture, and hardness is reduced, resulting in a significant decrease in mechanical properties such as wear resistance and breakage resistance. For this reason, conventionally, a large number of isolated substitutional nitrogen atoms have not been made to exist in a single crystal diamond. In contrast, the present inventors have found that, in the application of a tool used for sliding processing under a low load for a long time, a single crystal diamond containing a large number of the isolated substitutional nitrogen atoms has more excellent sliding property and exhibits more excellent wear resistance.

<Nitrogen-Atom Concentration>

The synthetic single crystal diamond of the present embodiment contains nitrogen atoms at a concentration of 200 ppm to 1500 ppm in terms of number of atoms (hereinafter, also referred to as "nitrogen-atom concentration"). A lower limit of the nitrogen-atom concentration in the synthetic single crystal diamond is 200 ppm or more, and may be 300 ppm or more, or 400 ppm or more, from the viewpoint of improving sliding property. An upper limit of the nitrogen-atom concentration in the synthetic single crystal diamond is 1500 ppm or less, and may be 1400 ppm or less, or 1300 ppm or less, from the viewpoint of improving wear resistance. The nitrogen-atom concentration in the synthetic single crystal diamond may be 200 ppm to 1500 ppm, 300 ppm to 1400 ppm, or 400 ppm to 1300 ppm.

The nitrogen-atom concentration N (ppm) of the synthetic single crystal diamond is calculated, by using the following Formula 1, from an absorption coefficient A (cm$^{-1}$) at a wavenumber of 1130 cm$^{-1}$ in an infrared absorption spectrum of the synthetic single crystal diamond measured by Fourier-transform infrared spectrometry.

$$N \text{ (ppm)} = 25 \cdot A \text{ (cm}^{-1}) \quad \text{Formula 1}$$

<First-order Raman Scattering Spectrum>

A Raman shift $\lambda 1$ cm$^{-1}$ of a peak in a first-order Raman scattering spectrum of the synthetic single crystal diamond of the present embodiment and a Raman shift $\lambda 2$ cm$^{-1}$ of a peak in a first-order Raman scattering spectrum of a synthetic IIa-type single crystal diamond that has a concentration of nitrogen atoms of 1 ppm or less in terms of number of atoms exhibit a relationship of the following Formula A,

$$-0.85 < \lambda 1 - \lambda 2 \leq -0.15 \quad \text{Formula A}.$$

A state of the internal stress of the synthetic single crystal diamond can be evaluated by comparing the Raman shift $\lambda 1$ cm$^{-1}$ of the peak in the first-order Raman scattering spectrum of the synthetic single crystal diamond and the Raman shift $\lambda 2$ cm$^{-1}$ of the peak in the first-order Raman scattering spectrum of a synthetic IIa-type single crystal diamond that has a concentration of nitrogen atoms of 1 ppm or less in terms of number of atoms (hereinafter, also referred to as the reference sample or the synthetic IIa-type single crystal diamond). Specifically, the state of the internal stress of the single crystal diamond can be evaluated with a size of a peak position shift amount represented by the difference between $\lambda 1$ and $\lambda 2$ ($\lambda 1 - \lambda 2$). The reason will be described below.

The synthetic IIa-type single crystal diamond used as the reference sample means a single crystal diamond, which is synthesized by a temperature-difference method at high temperature and high pressure, is highly pure and contains no lattice defect nor internal distortion. For example, such a single crystal diamond is commercially available as a highly pure IIa-type single crystal diamond manufactured by Sumitomo Electric Industries, Ltd. The synthetic IIa-type single crystal diamond has a concentration of nitrogen atoms in terms of number of atoms of 1 ppm or less, and thus contains few nitrogen atoms, and thereby the internal stress is absent in the diamond crystal. The synthetic IIa-type single crystal diamond exhibits one sharp and intense peak in the first-order Raman scattering spectrum. The Raman shift of this peak typically appears within a range of 1332 cm$^{-1}$ to 1333 cm$^{-1}$. The value of the Raman shift varies depending on an environment temperature during the measurement. The Raman shift herein is a value measured at room temperature (20°C to 25°C).

When isolated substitutional nitrogen atoms are present in the diamond crystal, the Raman shift occurs on a lower frequency side than that of the synthetic IIa-type single crystal diamond. In this case, tensile stress derived from the isolated substitutional nitrogen atoms is generated in the diamond crystal. On the other hand, the isolated substitutional nitrogen atoms are absent and an aggregation-type nitrogen atoms are present in the diamond crystal, the Raman shift shifts onto a higher frequency side than that of the synthetic IIa-type single crystal diamond. In this case, tensile stress is not generated or compressive stress is generated in the diamond crystal.

Therefore, the state of the internal stress of the synthetic single crystal diamond can be evaluated by comparing the values of the Raman shift $\lambda 1$ cm$^{-1}$ of the synthetic single crystal diamond and the Raman shift $A2$ cm$^{-1}$ of the synthetic IIa-type single crystal diamond.

Based on the above findings, the present inventors have made intensive investigation on a relationship between the size of the peak position shift amount represented by the difference between $\lambda 1$ cm$^{-1}$ and $\lambda 2$ cm$^{-1}$ ($\lambda 1 - \lambda 2$) cm$^{-1}$ and the wear resistance of the synthetic single crystal diamond particularly in a processing under a low load for a long time and consequently found that the synthetic single crystal diamond has excellent sliding property and exhibits excellent wear resistance when the ($\lambda 1 - \lambda 2$) cm$^{-1}$ exhibits a relationship of the following Formula A.

$$-0.85 < \lambda 1 - \lambda 2 \leq -0.15 \quad \text{Formula A}$$

When the ($\lambda 1 - \lambda 2$) satisfies the relationship of the above Formula A, the number of the isolated substitutional nitrogen atoms in the synthetic single crystal diamond is sufficiently large, and the synthetic single crystal diamond can have excellent sliding property and excellent wear resistance. A lower limit of the ($\lambda 1 - \lambda 2$) is more than -0.85, and may be -0.83 or more, -0.76 or more, or -0.68 or more, from the viewpoint of improving wear resistance. An upper limit of the ($\lambda 1 - \lambda 2$) is -0.15 or less, and may be - 0.20 or less, or -0.25 or less, from the viewpoint of improving sliding property. The ($\lambda 1 - \lambda 2$) is more than -0.85 and -0.15 or less, and may be -0.83 to -0.15, -0.76 to -0.20, or -0.68 to -0.25.

A half width W of the peak in the first-order Raman scattering spectrum of the synthetic single crystal diamond of the present embodiment may be 2.7 cm$^{-1}$ to 4.5 cm$^{-1}$. Here, the half width means a full width at half maximum (FWHM). Since the synthetic single crystal diamond of the present embodiment contains a large number of isolated substitutional nitrogen atoms, it is presumed that lattice distortion is caused by the isolated substitutional nitrogen atoms and leads to an increased half width W of the peak.

A large number of the isolated substitutional nitrogen atoms in the synthetic single crystal diamond of the present embodiment cause tensile stress in carbon atoms at a diamond surface, and a frequency of the detachment of atoms due to sliding for a long time is suppressed, and the wear due to fatigue is suppressed. Therefore, when the synthetic single crystal diamond of the present embodiment is used as a material for a wear-resistant tool such as a die, the tool can have excellent wear resistance for a long time.

A lower limit of the half width W may be 2.7 cm$^{-1}$ or more, 2.9 cm$^{-1}$ or more, or 3.1 cm$^{-1}$ or more, from the viewpoint of improving wear resistance. An upper limit of the half width W may be 4.5 cm cm$^{-1}$ or less, 4.3 cm$^{-1}$ or less, or 4.2 cm$^{-1}$ or less, from the viewpoint of improving sliding property. The half width W may be 2.7 cm$^{-1}$ to 4.5 cm$^{-1}$, 2.9 cm$^{-1}$ to 4.3 cm$^{-1}$, or 3.1 cm$^{-1}$ to 4.2 cm$^{-1}$.

The Raman shifts and the half widths of the peaks in the first-order Raman scattering spectra of synthetic single crystal diamond and the reference sample are measured with a microscopic Raman spectrometer. The measurement is performed at room temperature (20°C to 25°C) with excitation light at a wavelength of 532 nm using a laser. During the measurement, changes in temperature of a detector and an optical system of the Raman spectrometer are controlled within ±1°C or less.

A surface of the synthetic single crystal diamond is polished to measure the Raman shift $\lambda 1$ cm$^{-1}$ of the peak in the first-order Raman scattering spectrum of the polished surface. A surface of the synthetic IIa-type single crystal diamond, which is a reference sample, is polished to measure the Raman shift $\lambda 2$ cm$^{-1}$ of the peak in the first-order Raman scattering spectrum of the polished surface.

The Raman shifts $\lambda 1$ and $\lambda 2$ are wavenumbers at which the first-order Raman scattering spectrum signals become most intense. The peak shape is evaluated by peak-fitting treatment with Lorentz function or Gaussian function. The value of $(\lambda 1 - \lambda 2)$ cm$^{-1}$ is calculated based on the peak shape after the peak-fitting treatment. Based on the peak shape, the half width W of the peak in the first-order Raman scattering spectrum of synthetic single crystal diamond is determined.

<Infrared Absorption Spectrum>

In an infrared absorption spectrum of the synthetic single crystal diamond of the present embodiment measured by Fourier-transform infrared spectrometry, an absorption peak may be present in a wavenumber range of 2680 cm$^{-1}$ to 2695 cm$^{-1}$. The synthetic single crystal diamond having the absorption peak has further improved sliding property. Although the mechanism is not clear, the present inventors presume that the state of electron of the isolated substitutional nitrogen atoms in the crystal lattice is a preferable state for improving the sliding property.

In the present disclosure, the absorption peak present in a wavenumber range of 2680 cm$^{-1}$ to 2695 cm$^{-1}$ in the infrared absorption spectrum means that a maximum value is present on a chart produced by drawing a base line in a wavenumber range of 2680 cm$^{-1}$ to 2695 cm$^{-1}$ in an absorption spectrum chart, and the shape of the peak including the maximum value is a substantially symmetrical mountain shape.

In the infrared absorption spectrum of the synthetic single crystal diamond of the present embodiment measured by Fourier-transform infrared spectrometry, a maximum absorption intensity IA of the absorption peak in a wavenumber range of 2680 cm$^{-1}$ to 2695 cm$^{-1}$ may be 1.0% or more of an absorption intensity IB at a wavenumber of 2160 cm$^{-1}$. According to this, the sliding property of the synthetic single crystal diamond is further improved. Here, the absorption intensity IB at a wavenumber of 2160 cm$^{-1}$ is an absorption intensity derived from absorption by a phonon of diamond.

A lower limit of the percentage (IA/IB) $\times$ 100 of the maximum absorption intensity IA relative to the absorption intensity IB may be 1.0% or more, 1.5% or more, or 2.0% or more. An upper limit of the percentage (IA/IB) $\times$ 100 is not particularly limited, but can be set to, for example, 30% or less. The percentage (IA/IB) $\times$ 100 may be 1.0% to 30%, 1.5% to 0%, or 2.0% to 30%.

In the infrared absorption spectrum of the synthetic single crystal diamond of the present embodiment measured by Fourier-transform infrared spectrometry, an absorption peak derived from an aggregate of nitrogen atoms may be absent. Aggregates of nitrogen atoms exhibiting the absorption peaks in the infrared absorption spectrum are the A center, the B center, and the B' center. In other words, the synthetic single crystal diamond of the present embodiment may not include the A center, the B center, or the B' center. According to this, since most of the nitrogen atoms in the synthetic single crystal diamond are present as isolated substitutional nitrogen atoms, tensile stress is likely to increase, and the effect of suppressing the abrasion and wear is improved.

When the synthetic single crystal diamond includes the A center, an absorption peak A is present in a wavenumber range of 1280 cm$^{-1}$ to 1284 cm$^{-1}$ in the infrared absorption spectrum. When the synthetic single crystal diamond includes the B center, an absorption peak B is present in a wavenumber range from 1173 cm$^{-1}$ to 1177 cm$^{-1}$ in the

infrared absorption spectrum. When the synthetic single crystal diamond includes the B' center, an absorption peak C is present in a wavenumber range of 1358 cm$^{-1}$ to 1385 cm$^{-1}$ in the infrared absorption spectrum. When at least one of the absorption peak A, the absorption peak B, or the absorption peak C is present in the infrared absorption spectrum of the synthetic single crystal diamond, the absorption peak derived from the aggregate of nitrogen atoms is determined to be present in the infrared absorption spectrum. When none of the absorption peak A, the absorption peak B, and the absorption peak C are present in the infrared absorption spectrum of the synthetic single crystal diamond, the absorption peak derived from the aggregate of nitrogen atoms is determined to be absent in the infrared absorption spectrum.

Examples of the form of the nitrogen atom that may be included in the synthetic single crystal diamond of the present embodiment include an NV center in which a nitrogen atom and a vacancy are bonded to each other and an H3 center composed of two nitrogen atoms and a vacancy. The presence or absence of these cannot be confirmed by infrared absorption spectrum, but can be confirmed by luminescence.

The infrared absorption spectrum of synthetic single crystal diamond is produced by processing synthetic single crystal diamond into a plate with approximately 1 mm in thickness, polishing two surfaces thereof that transmit light to mirror surfaces, and then measuring an absorbance in the infrared region by Fourier-transform infrared spectroscopy. The measurement is performed at room temperature (20°C to 25°C). During the measurement, changes in temperature of a measuring device and a sample is controlled within ±1°C or less.

<{001}<100> Knoop Hardness>

A Knoop hardness in a <100> direction on {001} plane of the synthetic single crystal diamond of the present embodiment (also referred to as "{001}<100> Knoop hardness" herein) may be 65 GPa to 90 GPa. Herein, a generic plane orientation that includes crystal-geometrically equivalent plane orientations is represented by {}, and a generic direction that includes crystal-geometrically equivalent directions is represented by <>. A hardness in the <100> direction on {001} plane of a typical Ib type single crystal diamond (concentration of nitrogen atoms of 50 to 200 ppm in terms of number of atoms) is around 100 GPa. The synthetic single crystal diamond of the present embodiment may be lower than this. When the {001}<100> Knoop hardness of the synthetic single crystal diamond is 65 GPa or more, the synthetic single crystal diamond is much harder than metal materials, and thus can be suitably used for processing metal materials such as SUS, Ni alloys, and Ti alloys.

A lower limit of the {001}<100> Knoop hardness may be 65 GPa or more, 73 GPa or more, or 77 GPa or more. An upper limit of the {001}<100> Knoop hardness may be 90 GPa or less, 87 GPa or less, or 85 GPa or less. The {001}<100> Knoop hardness may be 65 GPa to 90 GPa, 73 GPa to 87 GPa, or 77 GPa to 85 GPa.

The {001}<100> Knoop hardness (hereinafter, also referred to as HK expressed in units of GPa) is measured in accordance with JIS Z 2251:2009 under conditions of a temperature of 23°C±5°C and a test load of 4.9 N. First, an indentation is formed in the <100> direction in the {001} plane of the synthetic single crystal diamond at a load of 4.9 N. Then, a longer diagonal line "a" (μm) of the formed indentation is measured, and the {001}<100> Knoop hardness (HK) is calculated from the following Formula 2.

$$\{001\}\langle100\rangle \text{ Knoop hardness (HK)} = 14229 \times 4.9/a^2 \qquad \text{Formula 2}$$

[Embodiment 2: Method for Manufacturing Synthetic Single Crystal Diamond]

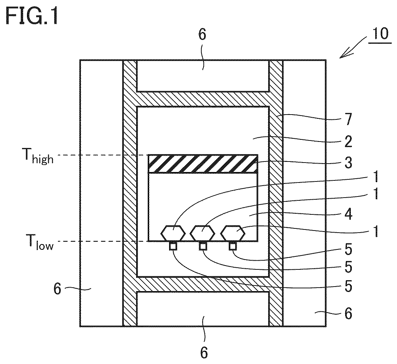

An example of a method for manufacturing the synthetic single crystal diamond of Embodiment 1 will be described hereinafter. The synthetic single crystal diamond of Embodiment 1 can be produced by a temperature-difference method using a sample chamber that has constitution illustrated in FIG. 1, for example.

As illustrated in FIG. 1, in a sample chamber 10 used for manufacturing a synthetic single crystal diamond 1, an insulator 2, a carbon source 3, a solvent metal 4, and a seed crystal 5 are disposed in a space surrounded by a graphite heater 7, and a pressure medium 6 is disposed outside the graphite heater 7. The temperature-difference method is a synthesis method in which a temperature gradient is provided inside the sample chamber 10 in a vertical direction, the carbon source 3 is disposed in a high-temperature portion ($T_{high}$), the seed crystal 5 of diamond is disposed in a low-temperature portion ($T_{low}$), the solvent metal 4 is interposed between the carbon source 3 and the seed crystal 5, and the synthetic single crystal diamond 1 is grown on the seed crystal 5 by holding conditions of a temperature equal to or higher than a temperature at which this solvent metal 4 is melted and a pressure equal to or higher than a pressure at which diamond is thermally stable.

As the carbon source 3, a diamond powder is preferably used. Graphite and pyrolyzed carbon can also be used.

As the solvent metal 4, one or more metals selected from iron (Fe), cobalt (Co), nickel (Ni), manganese (Mn), and the like, or alloys that contain these metals can be used. The solvent metal 4 may further contain one or more elements selected from the group consisting of titanium (Ti), vanadium (V), chromium (Cr), manganese (Mn), copper (Cu), zirconium (Zr), niobium (Nb), molybdenum (Mo), ruthenium (Ru), rhodium (Rh), hafnium (Hf), tantalum (Ta), tungsten (W), osmium (Os), iridium (Ir), and platinum (Pt).

Into the carbon source 3 or the solvent metal 4, a nitride such as iron nitride ($Fe_2N$ and $Fe_3N$), aluminum nitride (AlN), phosphorus nitride ($P_3N_4$), or silicon nitride ($Si_3N_4$), or an organic nitrogen compound such as melamine or sodium azide can be added as a single substance or a mixture as a nitrogen supply source, for example. As the nitrogen supply source, diamond or graphite that contains a large amount of nitrogen may also be added. This addition enables the synthesized synthetic single crystal diamond 1 to be synthesized to contain nitrogen atoms. In this case, the nitrogen atoms in the synthetic single crystal diamond 1 are present mainly as the isolated substitutional nitrogen atoms.

A content of the nitrogen supply source in the carbon source 3 or the solvent metal 4 is regulated so that the concentration of nitrogen atoms in the diamond single crystal to be synthesized is 200 ppm to 1500 ppm. A concentration of iron nitride ($Fe_3N$) in the solvent metal can be set to, for example, 0.01 to 0.15 mass% when the solvent metal is an alloy composed of iron-cobalt-nickel and the nitrogen supply source is iron nitride ($Fe_3N$).

When the synthetic single crystal diamond 1 is synthesized, the pressure and temperature are controlled to predetermined conditions using an ultrahigh pressure generator. Specifically, first, the temperature of the low-temperature portion is raised to 1350 to 1400°C. Next, with the temperature maintained, the pressure is increased to 5.5 GPa (hereinafter, also referred to as "first step"). Next, with the pressure maintained at 5.5 GPa, an electric power input to the ultrahigh pressure generator is gradually decreased over 60 hours so that the temperature of the low-temperature portion can be decreased to 1300°C±10°C (hereinafter, also referred to as "second step"). Thus, the synthetic single crystal diamond of the present embodiment 1 can be obtained. By setting the pressure and temperature conditions during synthesis as described in the first step and the second step, the obtained synthetic single crystal diamond can contain a large number of the isolated substitutional nitrogen atoms. Such synthesis conditions have been newly found by the present inventors.

In a conventional method for manufacturing a synthetic single crystal diamond using the temperature-difference method, the pressure and temperature during synthesis are kept constant in order to maintain stable crystal growth. Under such conditions, nitrogen atoms in the synthetic single crystal diamond tend to be present not only as the isolated-substitutional nitrogen atoms but also as aggregation-type nitrogen atoms. Therefore, it is impossible to realize a synthetic single crystal diamond in which Raman shifts $\lambda 1$ and $\lambda 2$ satisfy the relationship of the above Formula A by the conventional temperature-difference method.

EXAMPLE

The present embodiment will be more specifically described with Examples. However, the present embodiment is not limited to these Examples.

[Preparation of Synthetic Single Crystal Diamond]

Using a sample chamber having the structure shown in FIG. 1, diamond single crystals of each sample were synthesized by the temperature-difference method using a solvent metal.

An alloy composed of iron-cobalt-nickel was prepared as the solvent metal, and an iron nitride ($Fe_3N$) powder as a nitrogen supply source was added into the alloy. The concentration of iron nitride in the solvent metal is shown in the column "Iron Nitride Concentration Mass%" of "Manufacturing Conditions" in Table 1. For example, in Sample 2, the concentration of iron nitride in the solvent metal is 0.01 mass%.

A diamond powder was used for a carbon source, and approximately 0.5 mg of a diamond single crystal was used for a seed crystal. A temperature in the sample chamber was regulated with a heater so that a temperature difference of several tens of degrees was made between the high-temperature portion where the carbon source was disposed and the low-temperature portion where the seed crystal was disposed.

Using the ultrahigh pressure generator, the temperature of the low-temperature portion was first raised to the temperature described in the column "Temperature °C" of the "First Step" of the "Production Conditions" in Table 1. Then, the pressure was increased to 5.5 GPa with the temperature maintained (first step). Next, for samples with described "Performed" in the column "Second Step Input Power Regulation" in Table 1, the electric power input to the ultrahigh pressure generator was gradually decreased over 60 hours so that the temperature of the low-temperature portion was able to be deceased to 1300°C±10°C with the pressure maintained at 5.5 GPa (second step). For samples with described "Not Performed" in the column of "Second Step Input Power Regulation" in Table 1, the second step was not performed, and the temperature and pressure in the first step were maintained for 60 hours. Through the above steps, synthetic single crystal diamond of each sample was obtained.

[Table 1]

[Table 1]

Table 1

| Sample No | Manufacturing Conditions | | | Synthetic Single Crystal Diamond | | | | | | | {001} <100> Knoop Hardness | Sliding Test |
|---|---|---|---|---|---|---|---|---|---|---|---|---|
| | Iron Nitride Concentration | First Step | Second Step | Nirogen-Atom Concentration | Raman Spectrum | | Infrared Absorption Spectrum | | | | | Sliding Wear Scar Depth |
| | | Temperature | Input Power Regulation | | λ1-λ2 | Half Width W | Wavenumber 286 2695cm-1 Absorption Peak | (IA/IB) x100 | Nitrogen-Atom Aggregate Absorption Peak | | | |
| | Mass% | °C | | ppm | cm⁻¹ | cm⁻¹ | | % | | GPa | | μm |
| 1 | 0 | 1350 | Performed | 50 | -0.05 | 2.4 | Absence | 0.1 | Absence | 98 | | 2.00 |
| 2 | 0.01 | 1350 | Performed | 120 | -0.10 | 2.5 | Absence | 0.4 | Absence | 93 | | 1.50 |
| 3 | 0.02 | 1350 | Performed | 200 | -0.17 | 2.7 | Presence | 0.7 | Absence | 87 | | 0.85 |
| 4 | 0.03 | 1350 | Performed | 300 | -0.19 | 2.9 | Presence | 1.5 | Absence | 85 | | 0.65 |
| 5 | 0.04 | 1350 | Performed | 400 | -0.20 | 3.2 | Presence | 1.5 | Absence | 83 | | 0.53 |
| 6 | 0.05 | 1350 | Performed | 500 | -0.25 | 3.4 | Presence | 2.4 | Absence | 87 | | 0.42 |
| 7 | 0.05 | 1400 | Performed | 500 | -0.15 | 3.1 | Presence | 0.3 | Presence | 95 | | 0.50 |
| 8 | 0.05 | 1350 | Performed | 600 | -0.32 | 3.4 | Presence | 2.6 | Absence | 85 | | 0.35 |
| 9 | 0.07 | 1350 | Performed | 700 | -0.50 | 3.5 | Presence | 3.0 | Absence | 84 | | 0.33 |
| 10 | 0.08 | 1350 | Performed | 800 | -0.55 | 3.7 | Presence | 3.3 | Absence | 82 | | 0.31 |
| 11 | 0.09 | 1350 | Performed | 900 | -0.62 | 3.9 | Presence | 3.5 | Absence | 80 | | 0.29 |
| 12 | 0.10 | 1350 | Performed | 1000 | -0.68 | 4.2 | Presence | 4.2 | Absence | 77 | | 0.28 |
| 13 | 0.10 | 1400 | Performed | 1000 | -0.52 | 3.5 | Presence | 0.5 | Presence | 92 | | 0.35 |
| 14 | 0.13 | 1350 | Performed | 1300 | -0.76 | 4.3 | Presence | 4.5 | Absence | 73 | | 0.27 |
| 15 | 0.15 | 1350 | Performed | 1500 | -0.83 | 4.7 | Presence | 4.7 | Absence | 65 | | 0.26 |
| 16 | 0.13 | 1400 | Performed | 1500 | -0.60 | 3.6 | Presence | 0.7 | Presence | 90 | | 0.33 |
| 17 | 0.05 | 1350 | Net Performed | 300 | -0.13 | 2.5 | Presence | 1.4 | Presence | 92 | | 0.90 |

[Evaluation]

The obtained synthetic single crystal diamonds were subjected to a measurement of a nitrogen-atom concentration, Raman spectroscopic analysis, infrared spectroscopic analysis, a measurement of a Knoop hardness, and a sliding test.

<Measurement of Nitrogen-Atom Concentration>

A nitrogen-atom concentration in the synthetic single crystal diamond of each sample was measured. The specific measurement method is described in Embodiment 1, and thus the description thereof will not be repeated. The results are shown in the column "Nitrogen-Atom Concentration ppm" of "Synthetic Single Crystal Diamond" in Table 1.

<Raman Spectroscopic Analysis>

A first-order Raman scattering spectrum of the synthetic single crystal diamond of each sample was produced, and a value of $(\lambda 1 - \lambda 2)$ and a half width W of the peak were measured. The specific measurement method is described in Embodiment 1, and thus the description thereof will not be repeated. The results are shown in the columns "$\lambda 1 - \lambda 2$ cm$^{-1}$" and "Half Width W cm$^{-1}$" of "Raman Spectrum" of "Synthetic Single Crystal Diamond" in Table 1.

<Infrared Spectroscopic Analysis>

An infrared absorption spectrum of the synthetic single crystal diamond of each sample was produced, and presence or absence of an absorption peak within a wavenumber range of 2680 cm$^{-1}$ to 2695 cm$^{-1}$, a percentage (IA/IB) $\times$ 100 of a maximum absorption intensity IA of the absorption peak within a wavenumber range of 2680 cm$^{-1}$ to 2695 cm$^{-1}$ relative to an absorption intensity IB at wavenumber 2160 cm$^{-1}$, and presence or absence of an absorption peak derived from an aggregate of nitrogen atoms were confirmed or measured. The specific confirmation and measurement methods are described in Embodiment 1, and thus the description thereof will not be repeated. The results are shown in the columns "Wavenumber 2680 cm$^{-1}$-2695 cm$^{-1}$ Absorption Peak" and "(IA/IB) $\times$ 100 %" of "Synthetic Single Crystal Diamond" in Table 1.

<{001}<100> Knoop hardness >

A {001}<100> Knoop hardness of the synthetic single crystal diamond of each sample was measured. Since the specific confirmation and measurement methods have been described in Embodiment 1, the description thereof will not be repeated. The results are shown in the column "{001}<100> Knoop Hardness GPa" of "Synthetic Single Crystal Diamond" in Table 1.

<Sliding Test>

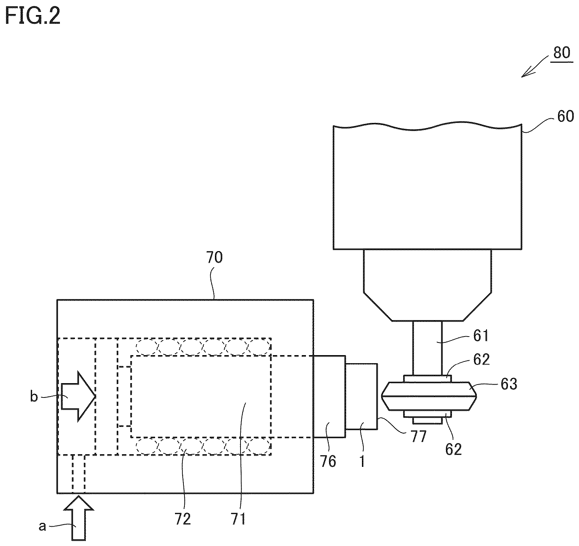

A sliding test was subjected to the synthetic single crystal diamond of each sample using a sliding test apparatus 80 illustrated in FIG. 2. The sliding test apparatus 80 includes a machining center 60 and a sample holder 70. The machining center 60 is provided with a spindle 61 and a fixing screw 62 to fix a SUS wheel 63 to the spindle 61. The sample holder 70 includes a jig 76 to hold the synthetic single crystal diamond 1 of each sample to be measured, an air cylinder 71 to move the jig 76 toward the SUS wheel 63, and a linear guide 72 disposed around the air cylinder 71. The SUS wheel 63 are disc-shaped with a diameter of 10 mm and a thickness of 2 mm, and a cutting edge is U-shaped with a cutting edge radius of 1 mm. A first surface 77 of the synthetic single crystal diamond 1 of each sample to be pressed against the SUS wheel 63 has a plate shape obtained by polishing with a diamond grinder. The first plane of the synthetic single crystal diamond 1 is a (100) plane.

Conditions of the sliding test are as follows. The following conditions correspond to a sliding processing under a low load for a long time.

Load: 0.5 N
Peripheral speed: 150 m/min
Test time: 200 minutes

At the end of the test (after 200 minutes), a depth of a sliding wear scar formed on the surface of the synthetic single crystal diamond 1 of each sample was measured. The results are shown in the column "Sliding Wear Scar Depth $\mu$m" of "Sliding Test" in Table 1. The smaller the depth of sliding wear scar, the better the sliding property of the synthetic single crystal diamond, and the better the wear resistance.

[Discussions]

Sample 3 to Sample 16 correspond to Examples. Sample 1, Sample 2, and Sample 17 correspond to Comparative Examples. Sample 3 to Sample 16 (Examples) exhibit a smaller sliding wear scar depth in the sliding test than Sample 1, Sample 2, and Sample 17 (Comparative Examples), and the wear resistance is confirmed to be excellent even in the sliding processing under a low load for a long time.

The embodiments and Examples of the present disclosure have been described as above, but appropriate combinations and various modifications of the constitution of the above each embodiment and Example are anticipated in advance.

The embodiments and Examples disclosed herein are examples in all the points, and should not be considered to be limitative. The scope of the present invention is described by not the aforementioned embodiments and Examples but the claims, and intended to encompass means equivalent to the claims and all modifications within the scope of the claims.

REFERENCE SIGNS LIST

1 synthetic single crystal diamond; 2 insulator; 3 carbon source; 4 solvent metal; 5 seed crystal; 6 pressure medium; 7 graphite heater; 10 sample chamber; 60 machining center; 61 spindle; 62 fixing screw; 63 SUS wheel; 70 sample holder; 71 air cylinder; 72 linear guide; 76 jig; 77 first surface; 80 sliding test apparatus.

**Claims**

1. A synthetic single crystal diamond, comprising nitrogen atoms at a concentration of 200 ppm to 1500 ppm in terms of number of atoms,
   wherein a Raman shift $\lambda 1$ cm$^{-1}$ of a peak in a first-order Raman scattering spectrum of the synthetic single crystal diamond and a Raman shift $\lambda 2$ cm$^{-1}$ of a peak in a first-order Raman scattering spectrum of a synthetic IIa-type single crystal diamond that has a concentration of nitrogen atoms of 1 ppm or less in terms of number of atoms exhibit a relationship of the following Formula A,

$$-0.85 < \lambda 1 - \lambda 2 \leq -0.15 \qquad \text{Formula A.}$$

2. The synthetic single crystal diamond according to Claim 1, wherein a half width W of the peak in the first-order Raman scattering spectrum of the synthetic single crystal diamond is 2.7 cm$^{-1}$ to 4.5 cm$^{-1}$.

3. The synthetic single crystal diamond according to Claim 1 or 2, wherein in an infrared absorption spectrum of the synthetic single crystal diamond measured by Fourier-transform infrared spectrometry, an absorption peak is present within a wavenumber range of 2680 cm$^{-1}$ to 2695 cm$^{-1}$.

4. The synthetic single crystal diamond according to any one of Claims 1 to 3, wherein in an infrared absorption spectrum of the synthetic single crystal diamond measured by Fourier-transform infrared spectrometry, a maximum absorption intensity IA of an absorption peak within a wavenumber range of 2680 cm$^{-1}$ to 2695 cm$^{-1}$ is 1.0% or more of an absorption intensity IB at a wavenumber of 2160 cm$^{-1}$.

5. The synthetic single crystal diamond according to any one of Claims 1 to 4, wherein

   a Knoop hardness in a <100> direction on a {001} plane of the synthetic single crystal diamond is 65 GPa to 90 GPa, and
   the Knoop hardness is measured in accordance with JIS Z 2251:2009 under conditions of a temperature of 23°C $\pm$5°C and a test load of 4.9 N.

6. The synthetic single crystal diamond according to any one of Claims 1 to 5, wherein in an infrared absorption spectrum of the synthetic single crystal diamond measured by Fourier-transform infrared spectrometry, an absorption peak derived from an aggregate of the nitrogen atoms is absent.

FIG.1

FIG.2

## INTERNATIONAL SEARCH REPORT

<table>
<tr><td>International application No.</td></tr>
<tr><td>**PCT/JP2023/045616**</td></tr>
</table>

### A. CLASSIFICATION OF SUBJECT MATTER

***C30B 29/04***(2006.01)i; ***C01B 32/25***(2017.01)i
FI:   C30B29/04 U; C30B29/04 W; C01B32/25

According to International Patent Classification (IPC) or to both national classification and IPC

### B. FIELDS SEARCHED

Minimum documentation searched (classification system followed by classification symbols)

C30B29/04; C01B32/25

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

### C. DOCUMENTS CONSIDERED TO BE RELEVANT

| Category* | Citation of document, with indication, where appropriate, of the relevant passages | Relevant to claim No. |
|---|---|---|
| X | CHEN, Liangchao et al. CrystEngComm. 2018, vol. 20, pp. 7164-7169, DOI: 10.1039/c8ce01533c<br>    table 1, fig. 4, 5 | 1-3, 5 |
| A | | 4, 6 |
| X | WO 2019/077844 A1 (SUMITOMO ELECTRIC INDUSTRIES, LTD.) 25 April 2019 (2019-04-25)<br>    table 1 | 1, 5 |
| A | | 2-4, 6 |
| A | JP 2017-7887 A (SUMITOMO ELECTRIC INDUSTRIES, LTD.) 12 January 2017 (2017-01-12)<br>    entire text, all drawings | 1-6 |
| A | WO 2021/106283 A1 (SUMITOMO ELECTRIC INDUSTRIES, LTD.) 03 June 2021 (2021-06-03)<br>    entire text, all drawings | 1-6 |

✓ Further documents are listed in the continuation of Box C.      ✓ See patent family annex.

| | |
|---|---|
| \* Special categories of cited documents:<br>"A"  document defining the general state of the art which is not considered to be of particular relevance<br>"D"  document cited by the applicant in the international application<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **21 February 2024** | **05 March 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

International application No.

**PCT/JP2023/045616**

| C. | DOCUMENTS CONSIDERED TO BE RELEVANT | |
|---|---|---|
| Category* | Citation of document, with indication, where appropriate, of the relevant passages | Relevant to claim No. |
| A | JP 2015-134718 A (ELEMENT SIX LIMITED) 27 July 2015 (2015-07-27)<br>entire text, all drawings | 1-6 |

Form PCT/ISA/210 (second sheet) (July 2022)

## INTERNATIONAL SEARCH REPORT
### Information on patent family members

| International application No. |
| --- |
| **PCT/JP2023/045616** |

| Patent document cited in search report | | | Publication date (day/month/year) | Patent family member(s) | | | Publication date (day/month/year) |
| --- | --- | --- | --- | --- | --- | --- | --- |
| WO | 2019/077844 | A1 | 25 April 2019 | US | 2020/0283927 table I | A1 | |
| | | | | EP | 3699330 | A1 | |
| | | | | CN | 111247276 | A | |
| | | | | KR | 10-2020-0072482 | A | |
| JP | 2017-7887 | A | 12 January 2017 | US | 2018/0141818 | A1 | |
| | | | | EP | 3312311 | A1 | |
| | | | | CN | 107614761 | A | |
| WO | 2021/106283 | A1 | 03 June 2021 | US | 2022/0411963 | A1 | |
| | | | | EP | 4067540 | A1 | |
| | | | | CN | 114729469 | A | |
| JP | 2015-134718 | A | 27 July 2015 | US | 2013/0192144 | A1 | |
| | | | | US | 2013/0205680 | A1 | |
| | | | | US | 2013/0205681 | A1 | |
| | | | | GB | 201012809 | D | |
| | | | | GB | 201012807 | D | |
| | | | | GB | 201009296 | D | |
| | | | | GB | 2481283 | A | |
| | | | | GB | 2481284 | A | |
| | | | | GB | 2481285 | A | |
| | | | | GB | 201009296 | D0 | |
| | | | | WO | 2011/151414 | A2 | |
| | | | | WO | 2011/151415 | A2 | |
| | | | | WO | 2011/151416 | A2 | |
| | | | | EP | 2576441 | A2 | |
| | | | | EP | 2576442 | A2 | |
| | | | | EP | 2576443 | A2 | |
| | | | | CN | 102939261 | A | |
| | | | | CN | 103038164 | A | |
| | | | | CN | 103038165 | A | |
| | | | | KR | 10-2013-0031316 | A | |
| | | | | KR | 10-2013-0041884 | A | |
| | | | | KR | 10-2013-0041885 | A | |

Form PCT/ISA/210 (patent family annex) (July 2022)

**EP 4 650 497 A1**

**Patent documents cited in the description**

- JP 2023002185 A

- WO 2019077888 A